(19) Europäisches Patentamt

European Patent Office

Office européen des brevets

(11) **EP 1 373 915 B1**

(12) **EUROPEAN PATENT SPECIFICATION**

(45) Date of publication and mention
of the grant of the patent:
**25.08.2004 Bulletin 2004/35**

(21) Application number: **02716165.2**

(22) Date of filing: **24.01.2002**

(51) Int Cl.7: **G01R 31/36**

(86) International application number:
**PCT/GB2002/000325**

(87) International publication number:
**WO 2002/061913 (08.08.2002 Gazette 2002/32)**

(54) **METHOD OF AND APPARATUS FOR ESTIMATING THE STATE OF CHARGE OF A BATTERY**

VERFAHREN UND ANORDNUNG ZUR BESTIMMUNG DES LADEZUSTANDES EINER BATTERIE

PROCEDE ET APPAREIL PERMETTANT L'ESTIMATION DE L'ETAT DE CHARGE D'UNE
BATTERIE

(84) Designated Contracting States:
**DE ES FR GB IT SE**

(30) Priority: **29.01.2001 GB 0102276**

(43) Date of publication of application:
**02.01.2004 Bulletin 2004/01**

(73) Proprietor: **Lucas Industries Limited
West Midlands B90 4LA (GB)**

(72) Inventor: **WAKEMAN, Anthony Claude
Halesowen B62 0LN (GB)**

(74) Representative: **Beck, Simon Antony et al
Withers & Rogers,
Goldings House,
2 Hays Lane
London SE1 2HW (GB)**

(56) References cited:
**EP-A- 0 987 555          EP-A- 1 049 231
US-A- 5 819 864**

**Description**

The present invention relates to a method of and apparatus for estimating the state of charge in a battery based on a measurement of the voltage at the terminals of the battery.

Hitherto, attempts have been made to estimate the state of charge of a battery using current sensors to monitor the flow of current into and out of a battery. However, in for example an automotive environment, the sensor may need to be responsive to the low currents drawn when a vehicle is parked, for example by the alarm system and the clock, whilst also being able to accurately measure the currents drawn during starting of the vehicle when the user may, for example, be seeking to start the vehicle with its lights on thereby giving rise to both the lighting load current and the starter motor current. Thus the current measuring apparatus may be required to accurately measure currents as low as 1 mA or less while also being able to accurately measure currents in excess of 250 amps. Additionally, the current sensing element must not give rise to any significant voltage drop in the electrical system. These stringent requirements limit the accuracy of current based battery state of charge monitors. Furthermore during charging a small portion of the current is effectively wasted by being involved in gassing reactions within the battery. However during discharging current efficiency is nearly 100%. Therefore integrating current flow tends to overestimate the state of charge of a battery. Furthermore, an open circuit battery is subject to self-discharge even though no external current is flowing and this self-discharge current reduces the state of charge of the battery in a similar manner to an external discharge current.

By contrast, the voltage across a battery only varies over a range of a few volts. However although the terminal voltage of a battery is easy to measure accurately, it has hitherto been difficult to reliably correlate this to the state of charge of a battery.

It has conventionally been the case that, if the battery had sufficient charge in it or if the car could be jump started, then it was drivable. However, the automotive industry is moving towards electrical steering and braking systems and as a result there is a need to be able to measure battery charge in order to confirm that the steering and braking systems can function correctly.

According to a first aspect of the present invention, there is provided a method of estimating the state of charge of a battery, the method comprising the steps of:

1. Monitoring the voltage at the terminals of the battery;

2. Comparing the measured battery voltage with an estimate of the internal voltage of the battery in order to obtain an over-voltage;

3. Supplying the over voltage to a-fraction function in order to obtain an-estimate of the rate of change of proportional state of charge of the battery.

It is thus possible to provide a model that can estimate the rate of change in the proportional state of charge of a battery based solely on the measurement of a voltage at the battery terminals. This can be integrated to obtain an estimate of the fractional or proportional state of charge.

The model estimates the proportional state of charge of the battery, that is whether the battery is fully charged, half charged, 10% charged and so on. It does this without the need for knowledge of the total charge capacity of the battery. This move to estimating the fraction of charge remaining in a battery is advantageous as it allows the system to estimate the relative state of charge of the battery without needing battery specific information.

Preferably a first fraction function is used when the over voltage is positive. The first fraction function may be held in a mathematical form for curve fitting or may be held as a look up table for ease of implementation.

The first fraction function may advantageously be represented by a quadratic or a cubic function. Higher order functions may be used to represent the first fraction function more accurately but may also incur an increased computational overhead.

Preferably a second fraction function is used when the over voltage is negative. Most preferably the second function is represented by a family of second functions. Each second function is advantageously a function of the proportional state of charge of the battery. The members of the family of second functions may be a linear function of over-voltage.

Preferably the fraction function is also a function of a battery temperature. The battery temperature may advantageously be used as part of discharge calculations, charge rate calculations and equilibrium voltage calculations, anomalous voltage calculations and lead sulphate area calculations.

Preferably the output of a rate of change of state of charge calculator is provided to an integrator which integrates the rate of change of state of charge to derive a measure of a change in charge and sums this with an historical estimate of the state of charge to derive a estimate of the present state of charge of the battery.

Preferably the estimate of the state of charge is available as an output from a battery monitoring device.

Preferably the estimate of the state of charge is provided as an input to an equilibrium voltage model which calculates the equilibrium voltage for the battery. This estimate of equilibrium voltage is provided as an input to a model for estimating the internal battery voltage.

Preferably the rate of change of state of charge estimate is also made available to an anomalous voltage calculator.

Advantageously the anomalous voltage is modelled as a hysteresis function. Preferably the hysteresis is modelled as a rhombic shape. The anomalous voltage then moves between the minimum and maximum values as a linear function of the amount of charge transferred into or out of the battery.

Preferably the model also includes a first battery chemistry model which estimates the contribution from one or more chemical processes within the battery. Advantageously the first battery chemistry model is arranged to estimate the amount of $PbSO_4$ covering the battery plates. This estimate may advantageously also be a fractional estimate (that is expressing the coverage as a fraction or proportion of the total plate area). The estimate of $PbSO_4$ depends on the state of charge of the battery and also on the recent operating conditions experienced by the battery. In particular the rate of change of charge during discharge, i.e. discharge current, changes the ability of a battery to accept charge. It has been observed that a battery can be recharged more quickly when it has recently been rapidly discharged. This is attributed to the lead sulphate deposition deposit having a larger surface area when the discharge current is large. The first battery chemistry model assumes that at, say, 50% state of charge, half the plate area is covered and half the active material of the plate is exposed, but that the true surface area of the $PbSO_4$ (in fractional or absolute terms) in contact with the acid depends on preceding discharge current and that this true surface area decreases with time.

According to a second aspect of the present invention, there is provided an apparatus for estimating the state of charge of a battery, the apparatus comprising a data processor responsive to a measurement of the voltage across a battery, and for performing the method according to the first aspect of the present invention.

Preferably the data processor is also responsive to a measurement of battery temperature which may be made by a temperature sensor in thermal contact with the battery.

According to a third aspect of the present invention, there is provided a computer program product for causing a data processor to perform the method according to the first aspect of the present invention.

The present invention will further be described, by way of example, with reference to the accompanying drawings, in which:

Figure 1 is a schematic diagram of an apparatus constituting an embodiment of the present invention;

Figure 2 is a graph of the equilibrium voltage of a battery versus state of charge;

Figure 3 is a graph showing voltage fluctuations during charge and discharging cycles;

Figure 4 is a graph illustrating the effect of stabilisation on the open circuit terminal voltage;

Figure 5 is a graph showing charge current versus state of charge for charging at a clamped charge voltage.

Figure 6 is a graph showing variation of anomalous voltage with respect to acid concentration;

Figure 7 schematically illustrates the internal functionality of the rate of charge of state of charge estimator; and

Figure 8 schematically illustrates a data processor for implementing the model;

Figure 9 is graph illustrating how polarisation voltage varies with respect to current;

Figure 10 is a graph illustrating how an ohmic fraction of polarisation varies with over voltage;

Figure 11 is a graph showing the form of the current discharge limit with state of charge;

Figure 12 is a graph showing how specific area of lead sulphate varies with discharge rate in the model;

Figure 13 is a graph showing the comparison of estimates from the model and real state of charge of a battery; and

Figure 14 is a graph illustrating the effect of discharge current and delay on acceptance of a charge current.

The response of a battery in both the short term and long term to charging and discharging is complex. The following discussion describes some of these responses such that the complexity of the task is not underestimated.

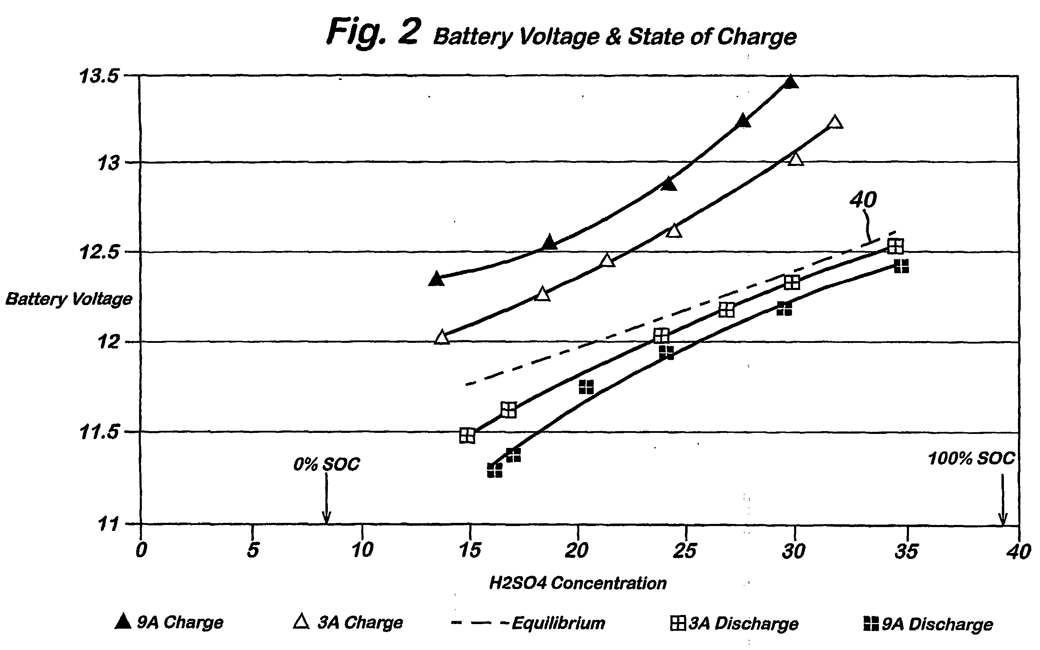

A number of prior attempts have been made to estimate the state of charge of a battery. Figure 2 is a graph illustrating the battery voltage versus the state of charge. With no current flowing the equilibrium terminal voltage of a battery, as represented by chain line 40 is almost a linear function of a state of charge of the battery. Indeed, many workers have studied the way in which voltage changes with acid concentration and temperature using both battery and electrode measurements, see for example "Storage Batteries" by G W Vinal, John Wiley & Son, 4th edition, 1955 tables 39 and 40, pages 192 and 194.

Although the relationship between state of charge and equilibrium voltage is fundamental, it cannot be used in practice in order to estimate the state of charge of a battery as it can take days or weeks for the battery voltage to settle to the true equilibrium voltage.

Figure 2 also shows that, during discharge, the battery voltage falls below the expected equilibrium voltage whereas during charge the battery voltage rises above the equilibrium voltage. The discrepancy between the measured voltage and the equilibrium voltage is largest at the fully charged and fully discharged conditions. It also varies with the rate at which the battery is charged or discharged.

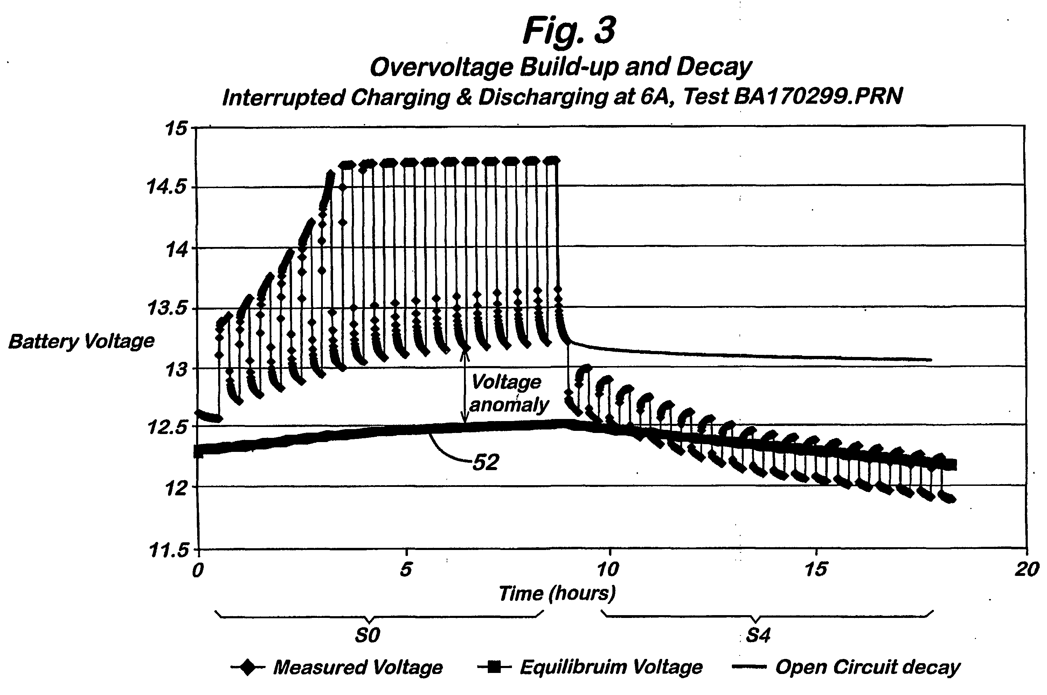

Figure 3 illustrates the results of an experiment to analyse the build-up and decay of over-voltage within a battery. In a first portion of the test, generally designated 50 the battery was cyclically charged at 6 amps for fifteen minutes and then left open circuit for fifteen minutes. This was repeated for nine hours. The battery charger included a voltage clamp preventing the battery terminal voltage rising above 14.7 volts. As can be seen, starting from time zero, the terminal voltage during charging rises from approximately 13.4 volts to the clamp voltage after 4 hours and then remains clamped. Whilst the battery is open circuit, the terminal voltage has also risen from approximately 12.6 volts at the beginning of the test to around 13.2 volts towards the end of the charging cycle after nine hours, and appears to be assymptoting towards a value of about 13.3 volts or so. The difference between the measured battery voltage at the end of the open circuit period, and the corresponding equilibrium voltage represented by the line labelled 52 represents the battery voltage anomaly. Thus, in the first nine hours, the battery voltage had not quite settled to the steady state value during each fifteen minutes open circuit period, however it is clear that the open circuit voltage is greater than the fully equilibrated voltage. Indeed, this voltage anomaly was present at time zero and increased with the number of ampere-hours of charge. In an extra run, the fully charged battery was left open circuit for nine hours by which time the open circuit battery voltage had decayed to 13.1 volts. The equilibrium voltage for this battery was measured at 12.5 volts so the anomalous voltage after nine hours was 0.6 volts.

During a second half of the test, generally indicated 54 the battery was intermittently discharged at 6 amps for fifteen minutes and then left open circuit for fifteen minutes in a repeated manner. During the discharge phase, the voltage when 6 amps of discharge current was flowing was approximately 0.4 volts lower than during the open circuit periods. However, this experiment gives little insight into the contribution of the various polarisation mechanisms that contribute to the voltage drop.

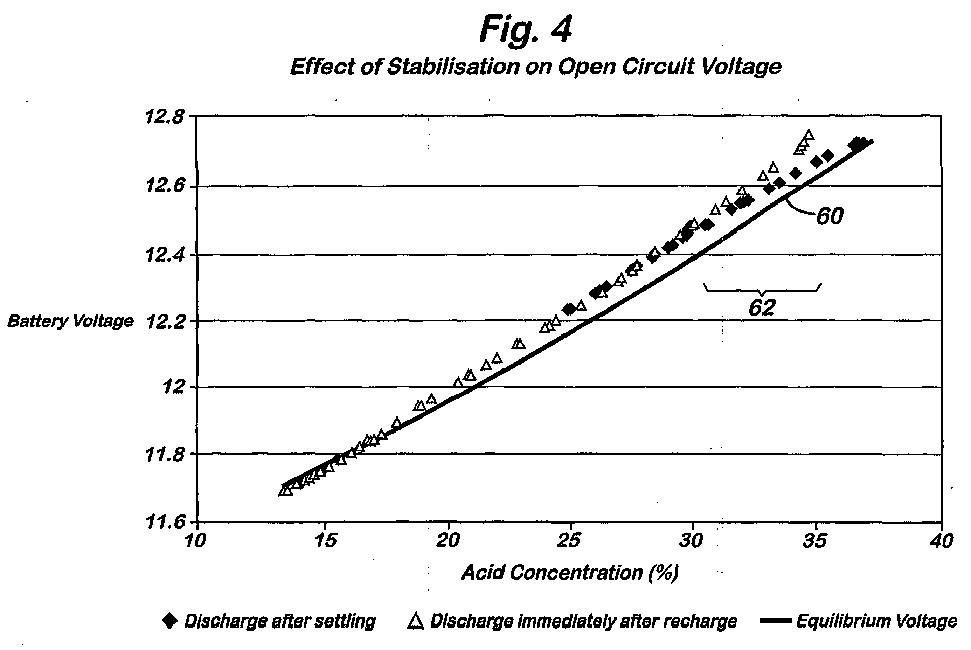

Figure 4 is a graph representing the open circuit voltage of a battery undergoing intermittent discharge with and without stabilisation. The equilibrium voltage of a battery is represented by the solid line 60. It is well known that, given sufficient settling time, the open circuit voltage decays to the equilibrium value. However, tests demonstrate that during an intermittent discharge of the type shown in Figure 3, the anomalous voltage gradually reappeared, as represented in region 62, and then the open circuit voltage for the remainder of the discharge was the same as for a freshly recharged battery.

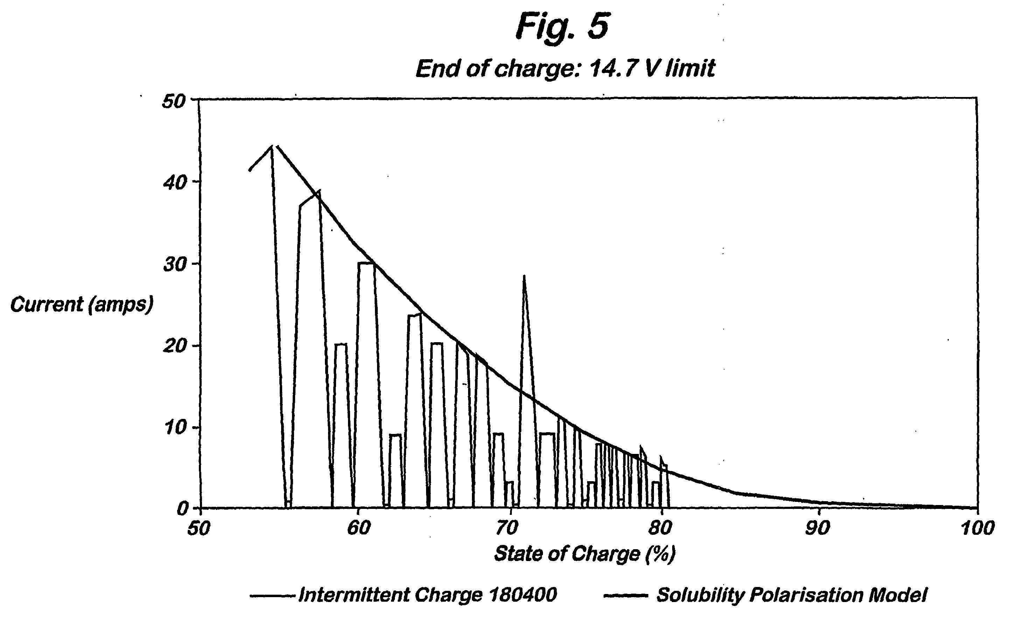

Figure 5 illustrates the results performed from a charging test where the charge voltage was clamped at 14.7 volts. As can be seen, as the end of the charging process is approached the charge current diminishes. The current is limited by the availability of active material to convert but the relationship is non-linear.

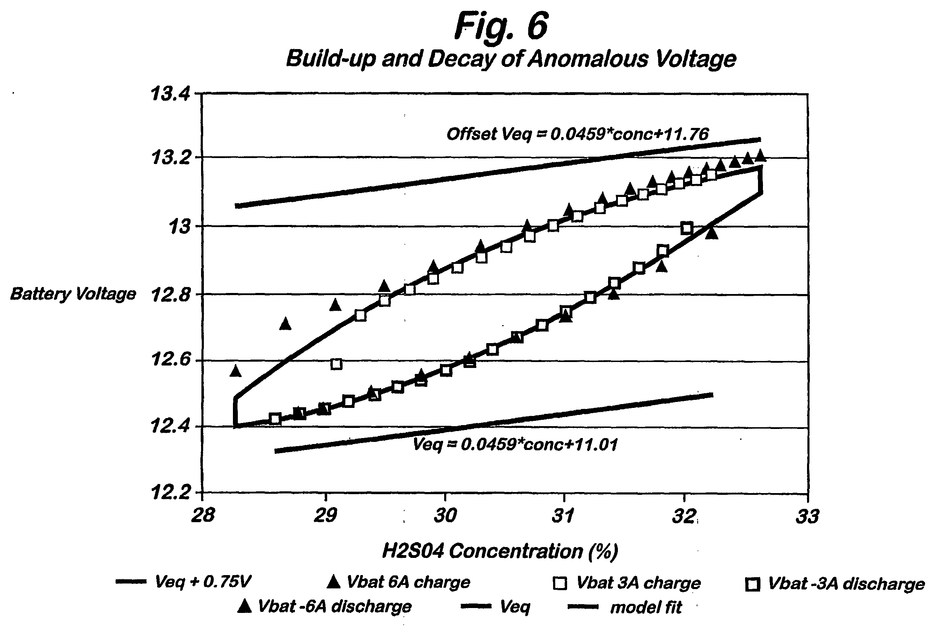

Figure 6 is a graph showing how the battery voltage varies as a result of the anomalous voltage in both charging and discharging at currents of 3 amps and 6 amps with differing states of charge as determined by the changing acid concentration.

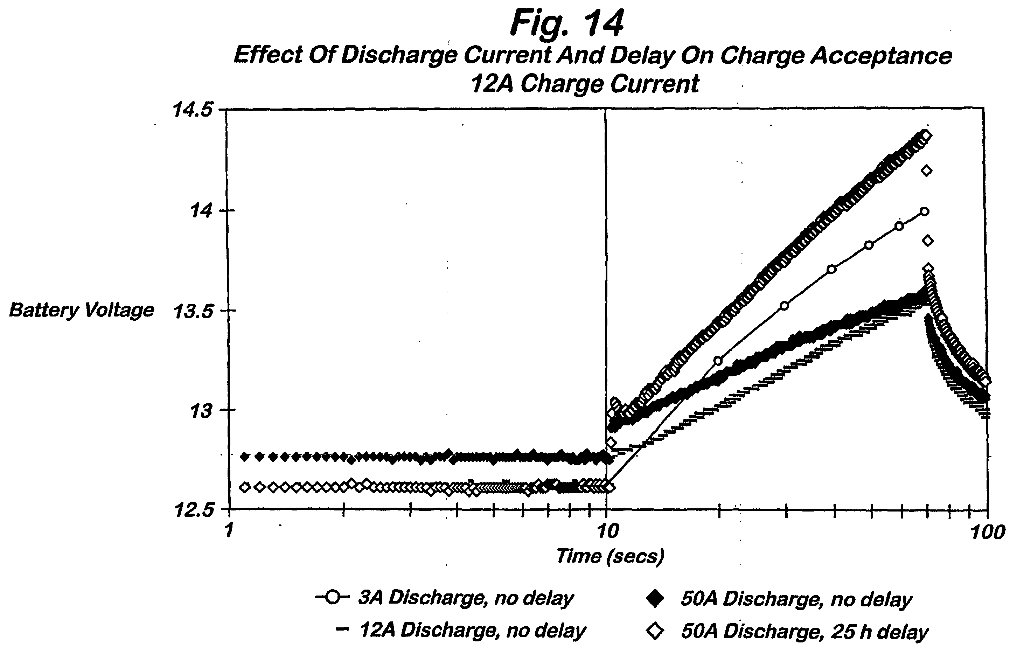

Figure 14 shows that the rate at which a battery can accept charge is affected by the rate of the previous discharge and the time that has elapsed between the end of discharge and the start of the charge. The rate at which the battery voltage increased during charging at 12 amps depended on the rate of the preceding discharge. The smallest discharge current, 3A was followed by the highest rate of voltage increase on charging and the 50A discharge had the lowest rate of voltage increase.

However, allowing a delay of 25 hours after a 50A discharge increased the rate of voltage increase to a level similar to that following the 3A discharge without a delay.

Although the recharges only lasted for one minute, other workers, for example Sharpe and Conell (*"Low temperature charging behaviour of lead-acid cells", T F SHARPE, R S CONELL, Journal of Applied Electrochemistry, 17 (1987), 789-799*) have shown that the effect persists throughout the recharging period.

Scanning electron microscope studies ("Dissolution and precipitation reactions of lead sulfate in positive and negative electrodes in lead acid battery", ZEN-ICHIRO TAKEHARA, Journal of Power Sources, 85 (2000), 29-37) have shown that the size of lead sulphate crystals deposited falls as the discharge current increases. The resulting greater surface area is believed to reduce the polarisation during subsequent charging. Presumably, the area decreases again if the battery is left in the open circuit condition.

In "Lead Acid Batteries" by H Bode, (ISBN 0-471-08455-7, John Wiley & Sons, 1977, page 136), equation 154 lists the five types of polarisation that can make up the total polarisation of an electrode:-

$$h = h_t + h_r + h_d + h_k + h_o$$

where

$h_t$ is the charge transfer (or activation) polarisation which varies with the logarithm of the current;

$h_r$ is the reaction polarisation - insignificant in both positive and negative electrodes of a lead acid battery;

$h_d$ is the diffusion polarisation that varies linearly with small currents but ultimately increasing the applied overvoltage does not change the current because it is limited by a diffusion process;

$h_k$ is the crystallisation polarisation that is associated with the formation of supersaturated solutions and varies with the logarithm of the current; and

$h_o$ is the ohmic polarisation associated with the resistance of the acid and the active materials and as the name suggests varies linearly with current.

A problem with prior art models is that the contributions over various causes of polarisation or voltage deviation could not be estimated until the current was known, but the current could not be calculated until the sum of the polarisation mechanisms was known. Solving these algebraic loops sometimes cause the model's estimate of current to oscillate.

The current model, using a fractional state of charge concept overcomes this algebraic loop problem.

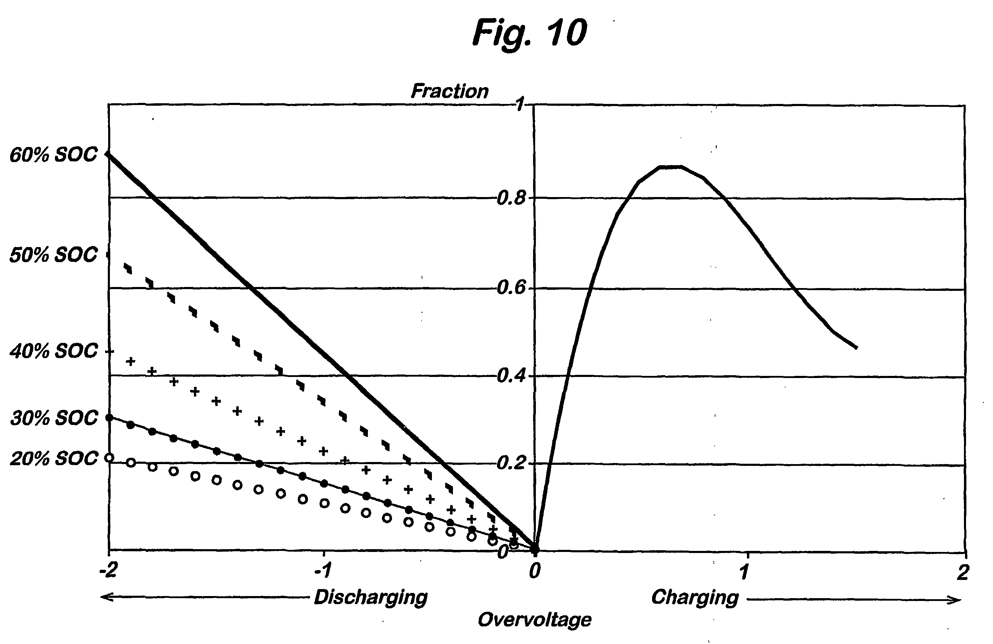

During discharging the fraction of total over-voltage due to ohmic polarisation is estimated. As the ohmic resistance is treated as constant, the current can be directly calculated from the estimated ohmic polarisation. The applicant has found that the fraction of the total polarisation attributable to the ohmic part increases linearly with the total polarisation. As is shown in Figure 10, the slope of this fraction with the total polarisation has been found to be dependent on the state of charge with small slopes at high states of charge and low states of charge and a maximum slope at around 50 - 60% state of charge.

During charging, the ohmic fraction passes through a maximum as the over voltage increases, but does not vary significantly with the state of charge.

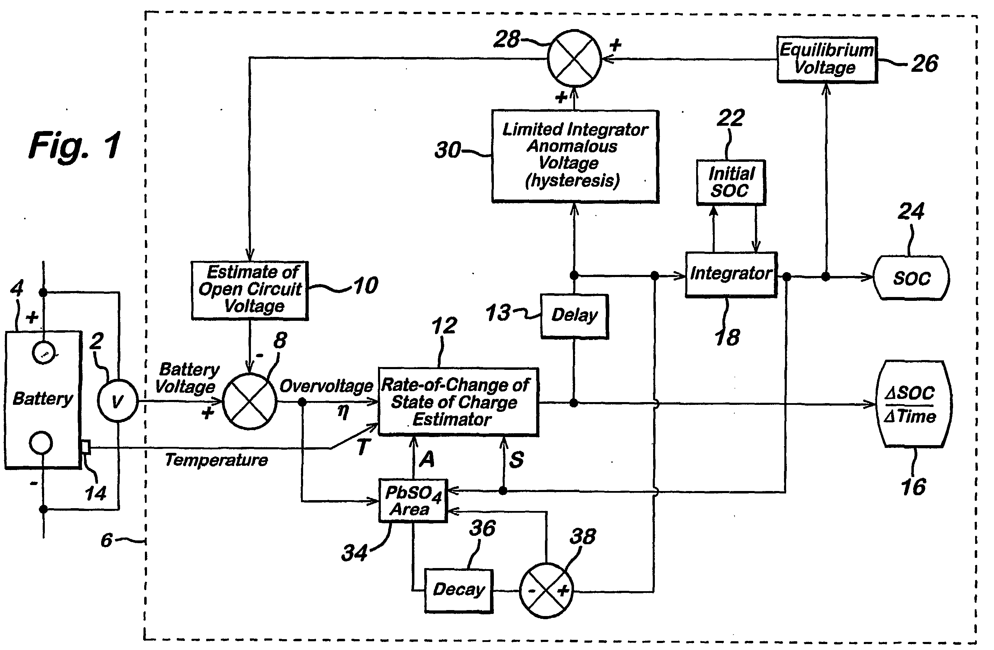

Figure 1 is a schematic representation of an apparatus for estimating the state of charge of a battery. As shown, a volt meter 2 is connected across the terminals of a battery 4 and provides a reading of the battery voltage to a voltage input V of a data processor 6.

In system terms, the output of the volt meter 2 is provided to the non-inverting input of a first summer 8. The inverting input of the first summer 8 receives an estimate of internal battery voltage from an internal voltage estimator 10. An output of the first summer is supplied to a voltage input of a rate of change of state of charge calculator 12. The rate of change of state of charge calculator 12 may also receive an input from a temperature sensor 14 provided in intimate contact with the battery 4. An output of the rate of change of state of charge calculator 12 is provided as a first system output 16 representing the rate of change of the state of charge of the battery with respect to time. The output from the rate of change of state of charge calculator 12 is also provided to a delay function 13 that outputs the rate of change of state of charge from the previous calculation cycle of the model. The delay function overcomes the calculation problem that the rate of change of state of charge requires an input of overvoltage but the overvoltage calculation is dependent on the rate of change of state of charge. Adding a delay has a negligible effect on the output of the integrators for anomalous voltage, state of charge and lead sulphate area as they change little in a single calculation cycle. The output of the delay function is provided to an input of an integrator 18 which integrates the rate of change of the state of charge and which combines this with a previous estimate of the state of charge held in a memory 22 in order to obtain an estimate of the charge held in the battery. The estimate of state of charge is provided at a second output 24 of the system.

An output from integrator 18 representing the state of charge is also provided as an input to an equilibrium voltage estimator 26 which uses the estimate of the state of charge of the battery to determine what the terminal voltage of the battery should be if it had been left for a prolonged period with no current flow to or from the battery.

As shown in Figure 2, the equilibrium voltage depends on the concentration of sulphuric acid and may be calculated with the following equation:-

EQUILIBRIUM VOLTAGE=0.0001419*conc*conc+0.001452*Temp+0.036729*conc+11.1403

Where temperature Temp is expressed in degrees Celsius.

The relationship between sulphuric acid concentration and state of charge is described in the prior art literature and is graphically represented in Figure 2.

The acid concentration may also be related to the state of charge via an expression

conc = conc (0%) + SOC(%)/100 * (conc (100%) - conc (0%))

The sulphuric acid concentrations at 0% and 100% state of charge (conc (0%) and conc(100%)) are characteristics of the particular battery being modelled.

The concentrations conc (0%) and conc (100%) can for simplicity be treated as constants. However, if it is desired to provide a model which copes with ageing batteries then it would be better to treat the above concentrations as variables in order to account for changes due to sulphation and paste shedding. The above concentrations may also vary between differing battery types.

An output of the equilibrium voltage calculator 26 is provided to a non-inverting input of a second summer 28.

The output of the delay function is also provided as an input to an anomalous voltage calculator 30 which provides an output to a second input of the second summer 28. An example of the build-up and decay of an anomalous voltage is shown in Figure 6. The lower line in Figure 6 shows how the equilibrium voltage changes with sulphuric acid concentration. The two curved lines show experimental values of open circuit voltage measured during interruptions to periods of charging and discharging. During charging (upper line) an anomalous voltage builds up in excess of the equilibrium value, approaching a steady value of about 0.6 volts in this case. The top line shows the equilibrium value offset by 0.65 volts. During discharge (lower curved line) the open circuit voltage approaches the equilibrium value asymptotically. It has been found by the applicant that the build-up and decay of this anomalous voltage can be satisfactorily modelled by assuming that the anomalous voltage builds up and decays linearly with charge (and hence acid concentration). In the case shown in Figure 6 the anomalous voltage moves from the minimum value of about 0.1 volts to the maximum of 0.6 volts with the passage of charge equivalent to about one fifth of the battery capacity. An output of the second summer 28 is provided as an input to the internal voltage estimator 10.

A PbSO4 area estimator 34 receives an estimate of over-voltage from the summer 8, an estimate of the rate of change of state of charge from the delay function 13 and an estimate of the state of charge from the integrator 18. When the estimated over-voltage indicates that the battery is discharging, the PbSO4 area estimator 34 calculates the specific area of the fresh deposits of PbSO4 and using the estimated state of charge, updates the average specific area of all the PbSO4 deposited. When the estimated over-voltage indicates that the battery is charging, the PbSO4 area estimator 34 leaves the average specific area unchanged as the total amount (and total area) of the PbSO4 reduces and supplies an estimate of the area of all the PbSO4 to the rate of change of state of charge calculator 12.

As described herein before, Figure 14 shows that the rate at which a battery can accept charge is affected by the rate of the previous discharge and the time that has elapsed between the end of discharge and the start of the charge. In order to describe this effect, the $PbSO_4$ estimator 34 effectively integrates the area of the PbSO4 deposited and increases the specific area with the discharge current.

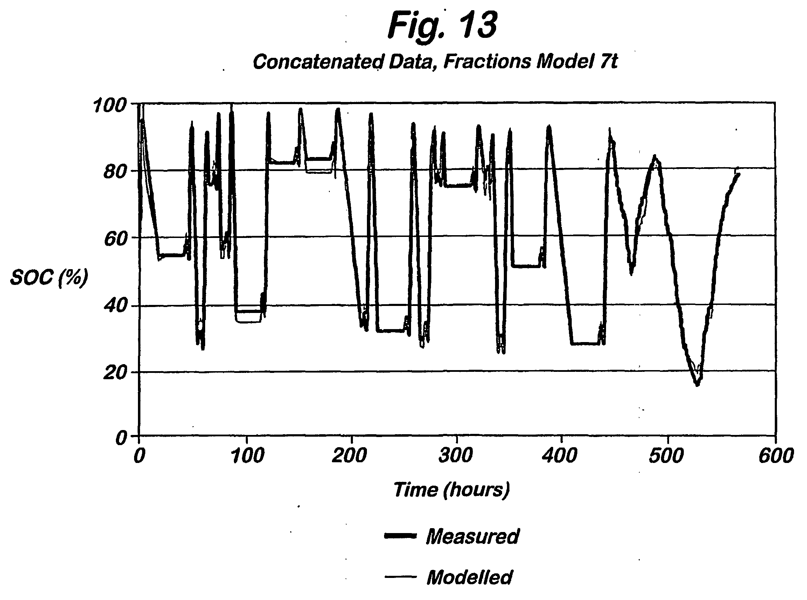

Figure 12 shows how the model represents the change in specific area with discharge rate. At high discharge rates, the specific area tends to a maximum of fifty times the minimum. specific area. The charge current is then calculated using the $PbSO_4$ area rather than the state of discharge. This has the effect of causing a faster recharge when following a high current discharge. During charging, the specific area does not change and the $PbSO_4$ area is reduced in direct proportion to the charge. The specific area reduces with time even when there is no discharge occurring. A Decay estimator 36 causes the specific area to decrease with time at a rate proportional to the difference between the specific area and the minimum specific area.

The decay estimator 36 provides an output to an inverting input of an adder 38. The output of the delay function 13 (rate of change of state of charge) is provided to the non-inverting input of the adder 38, and the output of the adder 38 is provided as an input to the PbSO4 area estimator 34. In order to cause the PbSO4 area to decay at the desired rate, the output of the decay estimator 36 is scaled to be equivalent to a rate of increase in state of charge before summing with the rate of change of state of charge from delay function 13. Therefore, if the output of the delay function is zero (no current flowing) the PbSO4 area estimator 34 sees an apparent charging current and so the PbSO4 area decays.

The model maintains an estimate of the open circuit voltage of the battery and subtracts this estimate from the measured battery voltage in order to obtain an estimate of polarisation. It is the calculation of the rate of change of state of charge of the battery from the estimate of polarisation which underlies the operation of the model. From this, the state of charge and the anomalous voltage are found by integration of the rate of change of state of charge.

The applicant has realised that in spite of the complications of battery chemistry and mechanisms occurring within a battery, the rate of change of state of charge of a battery can, in fact, be estimated with a good degree of accuracy from the polarisation voltage.

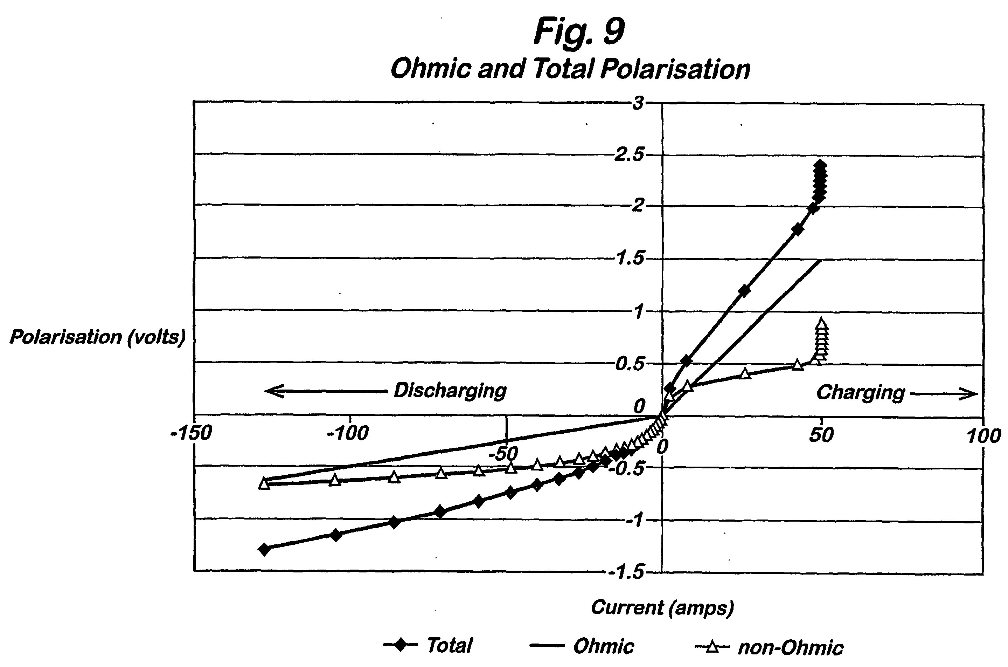

Figure 9 is a graph illustrating how the polarisation voltage varies with respect to current in both charging and discharging. The graph is clearly non-linear. Part of the polarisation can be attributed to the ohmic impedance of the battery and this can be measured under open circuit conditions with an AC instrument. During discharge, when the ohmic polarisation is subtracted from the total polarisation, the remainder is found to vary with the logarithm of the current. This is a characteristic of a process involving either charge transfer or crystallisation polarisation.

During charging, the total polarisation increases more rapidly with current and a limiting condition is reached where further increase in voltage does not result in an increase in charge current. Additionally, measurements of ohmic impedance indicates that the ohmic impedance is greater during charging than during discharging.

The calculation of current from the polarisation is complicated by the fact that the polarisation is the sum of over voltages which vary with the current and the logarithm of the current, as noted herein before algebraic loop techniques proceed by making a first guess of the current, calculate the ohmic, charge transfer (activation), diffusion and crystallisation polarisations, and compare the sum of these with the measured value and change the estimate of the current accordingly. A reasonable estimate of the current can be achieved after several successive approximations. However, this approach increases the calculation time and can lead to instabilities when step changes in the battery terminal voltage occur.

The insight underlying the present invention is that it is possible to estimate the ohmic polarisation as a fraction of the whole. Furthermore, during investigation the inventor has discovered that the ohmic fraction of the total polarisation can be described with relatively simple equations.

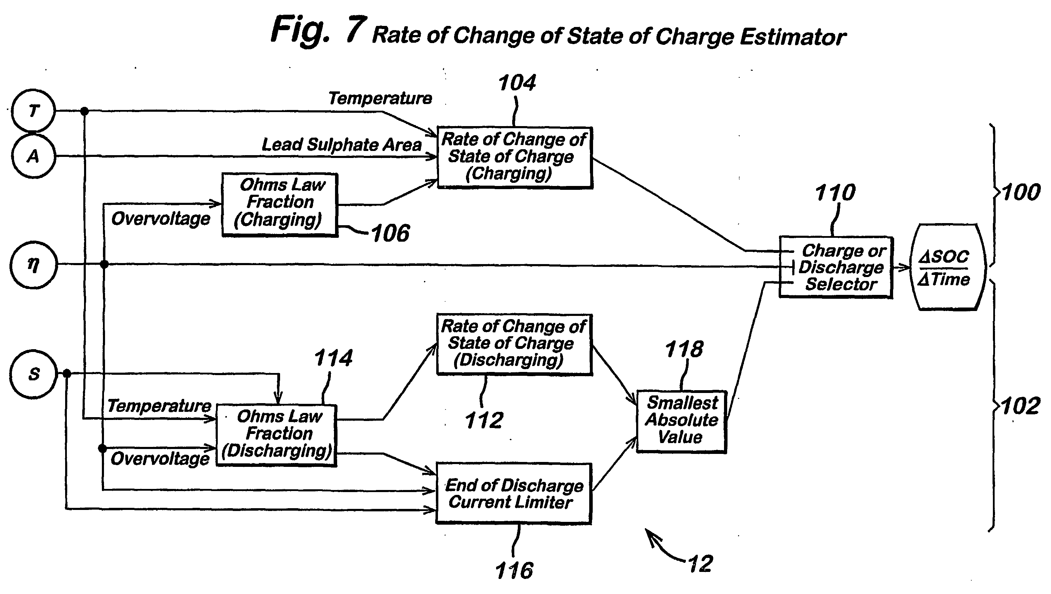

Figure 7 is a schematic of the internal layout of the rate of change of state of charge calculator.

The calculator comprises two portions, namely a charging portion 100 and a discharging portion 102.

The measurement of over-voltage $\eta$ is supplied to a selector 110 which examines the sign of the over-voltage to select whether the output of the charge portion 100 or the discharge portion 102 should be output from the calculator 12.

The charging portion comprises a charging version of the rate of change of state of charge model 104 which receives inputs representing temperature T, $PbSO_4$ area A, and the ohms law contribution from a calculator 106. The calculator 106 receives a measurement of the over-voltage $\eta$.

Figure 10 illustrates how the ohmic fraction has been found to vary with over voltage. The applicant has found that the ohmic fraction of the polarisation during charging can be described by:

$$\text{Fraction}_{(ohmic-c)} = \eta^3 - 3.36\eta^2 + 3.1\eta$$

Where $\eta$ is the total over voltage (i.e. the polarisation as these terms are synonymous)

The above cubic equation represents the ohmic fraction well whilst the polarisation is less than 1.5 volts. Above this voltage, the equation continues to increase the ohmic fraction when in reality this fraction starts to fall.

The open circuit voltage seen when a period of charging is interrupted is typically 13.2 volts and as a result the above equation should satisfactorily describe the performance of a battery up to a terminal voltage of 14.7 volts. However, additional corrections may need to be added to this equation where regulators permit higher terminal voltages during charging (for example during low temperatures).

In order to constrain the operation of the model the calculated ohmic fraction is limited to fall within the range 0.01 to 0.9. The rate of change of state of charge has been expressed in a unit "I20" which corresponds to the current required to discharge a battery in 20 hours. Thus, in the context of a 74 ampere hour battery the current corresponding to I20 is 3.7 amps.

The applicant has found that the charge rate can be described with the following equation:

$$\text{Charge Rate } (I_{20}) = c*\text{Fraction}_{(ohmic-c)}*(\eta)*PbSO_4\,\text{area}$$

Where :

$$c = 0.00095*T^2 + 0.0017*T + 0.0776$$

and

T is Temperature (in degree Celsius)

The calculation of $PbSO_4$ area was described earlier.

The discharging portion 102 comprises a discharging rate of change of state of charge calculator 112, an ohms law fraction calculator 114 and an end of discharge current limiter 116. The ohms law fraction calculator 114 receives measurements of temperature T, state of charge S and over-voltage $\eta$ and provides outputs to the rate of change of state of charge calculator 112 and the current limiter 116. The rate of change of state of charge calculator 112 uses this data to provide an estimate of the rate of change of state of charge to a first input of a selector 118.

During discharging, the applicant has found that the ohmic fraction changes linearly with the total over voltage as shown in Figure 10. As a precaution, the calculated ohmic faction during discharge is passed through a limiting function to keep the fraction in the range of 0.01 to 0.7.

The discharge current is found by dividing the ohmic polarisation by the battery impedance.

The end of discharge current limiter 116 also receives inputs representing the state of charge S and the over-voltage $\eta$ and derives a measurement of rate of change at state of charge modified by those effects which come into play in a highly discharged battery.

Figure 11 shows the decrease of the discharge current limit with state of charge for a 74 Ah capacity battery for an over voltage of -0.5 volts. The limit function is calculated as follows:

$$\text{Limit } (I_{20}) = \frac{(1-OhmicFraction)*\eta}{\exp(-0.1338*SOC)*2.875}$$

An output of the current limiter 116 is presented to a second input of selector 118 which selects the input having the smallest absolute value as its output This is then supplied to the selector 110.

The open circuit voltage of a freshly charged battery takes several days or weeks to fall to the equilibrium value. As the battery terminal voltage falls below the open circuit voltage estimated by the model, the rate of change of state of charge function 112 calculates a discharge rate which corresponds to the self-discharge rate of the battery. The integrators then reduce the anomalous voltage, state of charge and equilibrium voltages accordingly.

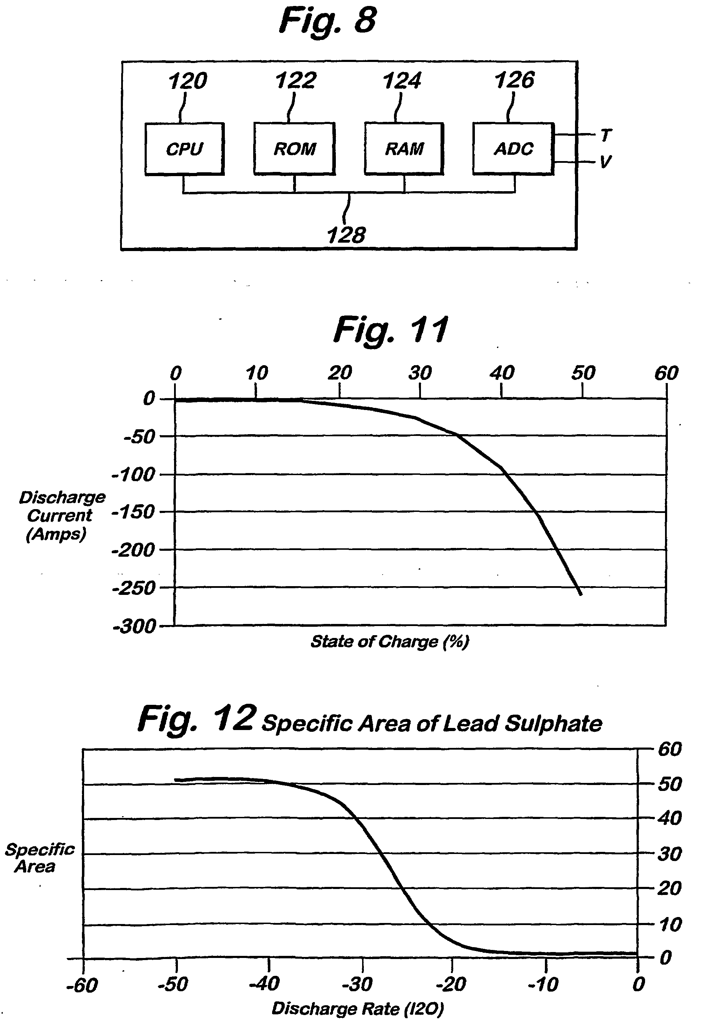

Figure 8 shows a data processor which may be suitably programmed to implement the present invention. The data processor is "embedded" within a vehicle and so conventional input and output devices such as a keyboard and VDU are not required.

The data processor comprises a central processing unit 120 which is interconnected to read only memory 122, random access memory 124 and an analogue to digital converter 126 via a bus 128. The analogue to digital converter receives the measurements of battery voltage and temperature and digitises them. The procedure used to implement the model is held in the read only memory 122 whereas the random access memory provides a store for temporary values used during the calculation

Figure 13 is a graph comparing the results of the simulation with actual state of charge data. The model matches the measured state of charge well, and is faster and more stable than prior art models.

It is thus possible by realising that the ohmic fraction of polarisation can be related to the total polarisation, to provide an accurate and relatively simple model and method for estimating battery state of charge.

## Claims

1. A method of estimating the state of charge of a battery, the method comprising the steps of

   a. Monitoring the voltage (v) at the terminals of a battery (4);

   b. Comparing the measured battery voltage with an estimate of the internal voltage of the battery in order to obtain an over voltage;

   c. Providing the over voltage to a fraction function in order to obtain an estimate of the rate of change of a proportional state of charge of the battery (2).

2. A method as claimed in claim 1, **characterised in that** a first fraction function is used when the over voltage is positive.

**3.** A method as claimed in claim 2, **characterised in that** the first function is represented as one of a mathematical function for curve fitting and a look up table.

**4.** A method as claimed in claim 2 or 3, **characterised in that** the first fraction function is represented by a quadratic, cubic or higher order function.

**5.** A method as claimed in any of the preceding claims, **characterised in that** a second fraction function is used when the over voltage is negative.

**6.** A method as claimed in claim 5, in which the second function is represented by a family of second functions, each of which is a function of the proportional state of charge of the battery (4).

**7.** A method as claimed in claim 6, **characterised in that** the second functions are linear functions of over voltage.

**8.** A method as claimed in any one of the preceding claims, **characterised in that** the method further takes account of the temperature of the battery.

**9.** A method as claimed in any one of the preceding claims in which an output of a rate of change of the state of charge calculator is integrated in order to determine the state of charge.

**10.** A method as claimed in claim 9, **characterised in that** the estimate of the state of charge is provided to an input of a equilibrium voltage estimator (26) in order to provide an estimate of the equilibrium voltage of the battery as a function of the state of charge of the battery.

**11.** A method as claimed in any one of the preceding claims, **characterised in that** the estimate of rate of change of state of charge is provided as an input to an anomalous voltage calculator (30).

**12.** A method as claimed in claim 11 when dependent on claim 10, **characterised in that** the estimate of the open circuit voltage is the sum of the estimate of the equilibrium voltage and the anomalous voltage.

**13.** A method as claimed in any one of the preceding claims in which an estimate of $PbSO_4$ area is formed as a function of over voltage, an estimate of rate of change of state of charge, and an estimate of the state of charge, and in which the estimate of $PbSO_4$ area is used during the estimate of the rate of change of state of charge during battery charging.

**14.** A method as claimed in any one of the preceding claims in which an ohmic fraction of battery polarisation is derived as a cubic function of the over voltage.

**15.** A method as claimed in claim 14, **characterised in that** the ohmic fraction of battery polarisation is constrained to lie within the range 0.01 to 0.9.

**16.** A method as claimed in claim 14 or 15, in which the charge rate is modelled as the product of a temperature dependent function, the ohmic fraction of polarisation, the over voltage and $PbSO_4$ area.

**17.** A method as claimed in claim 6, **characterised in that** the second functions describe the ohmic fraction of polarisation and vary linearly with over voltage.

**18.** A method as claimed in claim 17, **characterised in that** the discharge current is found by dividing the ohmic polarisation by the battery impedance.

**19.** A data processor (6) estimating the charge in a battery in accordance with the method steps claimed in any one of the preceding claims.

**Patentansprüche**

**1.** Verfahren zur Abschätzung des Ladezustandes einer Batterie, welches Verfahren die Schritte aufweist des

a. Messens der Spannung (v) an den Anschlüssen einer Batterie (4);

b. Vergleichens der gemessenen Batteriespannung mit einem Schätzwert der internen Spannung der Batterie, um eine Überspannung zu erhalten;

c. Vorsehens der Überspannung für eine Bruchteilfunktion, um einen Schätzwert der Rate der Änderung eines proportionalen Ladezustandes der Batterie (4) zu erhalten.

2. Verfahren wie in Anspruch 1 beansprucht, **dadurch gekennzeichnet, dass** eine erste Bruchteilfunktion benutzt wird, wenn die Überspannung positiv ist.

3. Verfahren wie in Anspruch 2 beansprucht, **dadurch gekennzeichnet, dass** die erste Funktion als mathematische Funktion für Kurvendekkungsanalyse oder als eine Verweistabelle dargestellt wird.

4. Verfahren wie in Anspruch 2 oder 3 beansprucht, **dadurch gekennzeichnet, dass** die erste Bruchteilfunktion durch eine quadratische Funktion, kubische Funktion oder Funktion höherer Ordnung dargestellt wird.

5. Verfahren wie in einem der vorausgehenden Ansprüche beansprucht, **dadurch gekennzeichnet, dass** eine zweite Bruchteilfunktion benutzt wird, wenn die Überspannung negativ ist.

6. Verfahren wie in Anspruch 5 beansprucht, bei dem die zweite Funktion durch eine Familie von zweiten Funktionen dargestellt wird, von denen jede eine Funktion des proportionalen Ladezustandes der Batterie (4) ist.

7. Verfahren wie in Anspruch 6 beansprucht, **dadurch gekennzeichnet, dass** die zweiten Funktionen lineare Funktionen der Überspannung sind.

8. Verfahren wie in einem der vorausgehenden Ansprüche beansprucht, **dadurch gekennzeichnet, dass** das Verfahren außerdem die Temperatur der Batterie berücksichtigt.

9. Verfahren wie ein einem der vorausgehenden Ansprüche beansprucht, bei welchem ein Ausgangssignal eines Rechners für die Rate der Änderung des Ladezustandes integriert wird, um den Ladezustand zu ermitteln.

10. Verfahren wie in Anspruch 9 beansprucht, **dadurch gekennzeichnet, dass** der Schätzwert des Ladezustandes an einen Eingang eines Abschätzers (26) für Gleichgewichtsspannung geliefert wird, um einen Schätzwert der Gleichgewichtsspannung der Batterie als eine Funktion des Ladezustandes der Batterie zu liefern.

11. Verfahren wie in einem der vorausgehenden Ansprüche beansprucht, **dadurch gekennzeichnet, dass** der Schätzwert der Rate der Änderung des Ladezustandes als eine Eingabe für einen Rechner (30) für anormale Spannung vorgesehen ist.

12. Verfahren wie in Anspruch 11, bei Abhängigkeit von Anspruch 10, beansprucht, **dadurch gekennzeichnet, dass** der Schätzwert der Spannung bei offenem Stromkreis die Summe aus dem Schätzwert der Gleichgewichtsspannung und der anormalen Spannung ist.

13. Verfahren wie in einem der vorausgehenden Ansprüche beansprucht, bei dem ein Schätzwert der $PbSO_4$-Fläche als Funktion der Überspannung, ein Schätzwert der Rate der Änderung des Ladezustandes sowie ein Schätzwert des Ladezustandes gebildet werden und bei dem der Schätzwert der $PbSO_4$-Fläche während des Abschätzens der Rate der Änderung des Ladezustandes während der Batterieladung benutzt wird.

14. Verfahren wie in einem der vorausgehenden Ansprüche beansprucht, bei dem ein ohmischer Bruchteil der Batteriepolarisation als kubische Funktion der Überspannung abgeleitet wird.

15. Verfahren wie in Anspruch 14 beansprucht, **dadurch gekennzeichnet, dass** der ohmische Bruchteil der Batteriepolarisation so eingegrenzt wird, dass er innerhalb des Bereiches von 0,01 bis 0,9 liegt.

16. Verfahren wie in Anspruch 14 oder 15 beansprucht, bei dem die Laderate als Produkt einer temperaturabhängigen Funktion, des ohmischen Bruchteiles der Polarisation, der Überspannung und der $PbSO_4$-Fläche nachgebildet wird.

17. Verfahren wie in Anspruch 6 beansprucht, **dadurch gekennzeichnet, dass** die zweiten Funktionen den ohmischen

**EP 1 373 915 B1**

Bruchteil der Polarisation beschreiben und sich mit der Überspannung linear ändern.

18. Verfahren wie in Anspruch 17 beansprucht, **dadurch gekennzeichnet, dass** der Entladestrom gefunden wird, indem die ohmische Polarisation durch die Batterieimpedanz geteilt wird.

19. Datenprozessor (6), der die Ladung in einer Batterie gemäß den Verfahrensschritten abschätzt, die in einem der vorausgehenden Ansprüche beansprucht sind.

**Revendications**

1. Procédé pour estimer l'état de charge d'une batterie, le procédé comprenant les étapes consistant à:

   a) surveiller la tension (v) aux bornes d'une batterie (4);
   b) comparer la tension de batterie mesurée avec une estimation de la tension interne de la batterie en vue d'obtenir une surtension; et
   c) fournir la surtension à une fonction de fraction en vue d'obtenir une estimation de la vitesse de variation d'un état de charge proportionnel de la batterie (2).

2. Procédé selon la revendication 1, **caractérisé en ce qu'**une première fonction de fraction est utilisée lorsque la surtension est positive.

3. Procédé selon la revendication 2, **caractérisé en ce que** la première fonction est représentée comme une parmi une fonction mathématique pour un ajustement de courbe et une table de conversion.

4. Procédé selon la revendication 2 ou 3, **caractérisé en ce que** la première fonction de fraction est représentée par une fonction quadratique, cubique ou d'ordre supérieur.

5. Procédé selon l'une quelconque des revendications précédentes, **caractérisé en ce qu'**une deuxième fonction de fraction est utilisée lorsque la surtension est négative.

6. Procédé selon la revendication 5, dans lequel la deuxième fonction est représentée par une famille de deuxièmes fonctions, chacune d'elles étant une fonction de l'état proportionnel de la charge de la batterie (4).

7. Procédé selon la revendication 6, **caractérisé en ce que** les deuxièmes fonctions sont des fonctions linéaires de la surtension.

8. Procédé selon l'une quelconque des revendications précédentes, **caractérisé en ce que** le procédé tient en outre compte de la température de la batterie.

9. Procédé selon l'une quelconque des revendications précédentes, dans lequel une sortie d'un calculateur de la vitesse de variation de l'état de charge est intégrée en vue de déterminer l'état de charge.

10. Procédé selon la revendication 9, **caractérisé en ce que** l'estimation de l'état de charge est fournie par une entrée d'un estimateur de tension d'équilibre (26) en vue de fournir une estimation de la tension d'équilibre de la batterie en fonction de l'état de charge de la batterie.

11. Procédé selon l'une quelconque des revendications précédentes, **caractérisé en ce que** l'estimation de la vitesse de variation de l'état de charge est fournie comme une entrée à un calculateur de tension anormale (30).

12. Procédé selon la revendication 11 lorsqu'elle dépend de la revendication 10, **caractérisé en ce que** l'estimation de la tension de circuit ouvert est la somme de l'estimation de la tension d'équilibre et de la tension anormale.

13. Procédé selon l'une quelconque des revendications précédentes, dans lequel une estimation de la surface du $PbSO_4$ est formée en fonction de la surtension, d'une estimation de la vitesse de variation de l'état de charge et d'une estimation de l'état de charge, et dans lequel l'estimation de la surface du $PbSO_4$ est utilisée durant l'estimation de la vitesse de variation de l'état de charge durant la charge de la batterie.

**14.** Procédé selon l'une quelconque des revendications précédentes, dans lequel une fraction ohmique d'une polarisation de batterie est dérivée comme une fonction cubique de la surtension.

**15.** Procédé selon la revendication 14, **caractérisé en ce que** la fraction ohmique de la polarisation de batterie est limitée de manière à demeurer à l'intérieur de la gamme allant de 0,01 à 0,9.

**16.** Procédé selon la revendication 14 ou 15, dans lequel la vitesse de charge est modélisée comme étant le produit d'une fonction dépendant de la température, de la fraction ohmique de polarisation, de la surtension et de la surface du $PbSO_4$.

**17.** Procédé selon la revendication 6, **caractérisé en ce que** les deuxièmes fonctions décrivent la fraction ohmique de polarisation et varient d'une façon linéaire avec la surtension.

**18.** Procédé selon la revendication 17, **caractérisé en ce que** le courant de décharge est obtenu en divisant la polarisation ohmique par l'impédance de la batterie.

**19.** Processeur de données (6) estimant la charge d'une batterie suivant les étapes de procédé revendiquées dans l'une quelconque des revendications précédentes.

**Fig. 1**

**Fig. 2** *Battery Voltage & State of Charge*

Battery Voltage vs H2SO4 Concentration

100% SOC

0% SOC

40

Battery Voltage: 13.5, 13, 12.5, 12, 11.5, 11

H2SO4 Concentration: 0, 5, 10, 15, 20, 25, 30, 35, 40

▲ 9A Charge    △ 3A Charge    — — Equilibrium    ⊞ 3A Discharge    ▓ 9A Discharge

14

# Fig. 3

## Overvoltage Build-up and Decay
### Interrupted Charging & Discharging at 6A, Test BA170299.PRN

Battery Voltage

Voltage
anomaly

52

Time (hours)

S0

S4

◆ Measured Voltage   ■ Equilibruim Voltage   —— Open Circuit decay

EP 1 373 915 B1

# Fig. 4

## Effect of Stabilisation on Open Circuit Voltage

Battery Voltage

*Acid Concentration (%)*

◆ *Discharge after settling*   △ *Discharge immediately after recharge*   —— *Equilibrium Voltage*

EP 1 373 915 B1

## Fig. 5

### End of charge: 14.7 V limit

Current (amps)

State of Charge (%)

———Intermittent Charge 180400        ——— Solubility Polarisation Model

EP 1 373 915 B1

## Fig. 6
### Build-up and Decay of Anomalous Voltage

Offset $Veq = 0.0459*conc + 11.76$

Battery Voltage

$Veq = 0.0459*conc + 11.01$

H2S04 Concentration (%)

—— Veq + 0.75V    ▲ Vbat 6A charge    ☐ Vbat 3A charge    ☐ Vbat -3A discharge

▲ Vbat -6A discharge    —— Veq    —— model fit

EP 1 373 915 B1

# Fig. 7 Rate of Change of State of Charge Estimator

# Fig. 8

# Fig. 11

# Fig. 12 Specific Area of Lead Sulphate

## Fig. 9
### Ohmic and Total Polarisation

Polarisation (volts)

Discharging ←

Charging →

Current (amps)

◆ Total — Ohmic △ non-Ohmic

EP 1 373 915 B1

Fig. 10

EP 1 373 915 B1

## Fig. 13

**Concatenated Data, Fractions Model 7t**

- ▬ Measured
- — Modelled

EP 1 373 915 B1

# Fig. 14
## Effect Of Discharge Current And Delay On Charge Acceptance
## 12A Charge Current

-O- 3A Discharge, no delay

◆ 50A Discharge, no delay

− 12A Discharge, no delay

◇ 50A Discharge, 25 h delay

EP 1 373 915 B1